# EUROPEAN PATENT APPLICATION

(11) **EP 1 973 119 A2**
(43) Date of publication of application: **24.09.2008**
(21) Application number: 07291508.5
(22) Date of filing: 12.12.2007
(51) Int. Cl.: H01B 1/22

(54) **Anisotropic conductive film and adhesion method thereof**

(30) Priority: 19.03.2007 KR 20070026728
(71) Applicant: Toray Saehan Inc., Gyeongsangbuk-do (KR)
(72) Inventor: Sim, Chang-Hoon, Seoul (KR); Jun, Hae-Sang, Seoul (KR); Moon, Ki-Jeong, Seoul (KR)
(74) Representative: Bredema

(57) **Abstract**

The invention concerns an anisotropic conductive film used for adhering IC, e.g., LCD displays, etc. The conductive film is characterized by comprising a thermosetting adhesive, super-paramagnetic metal oxide nano-particles, and conductive particles, the super-paramagnetic metal oxide nano-particles and the conductive particles being dispersed in a thermosetting composition. With such a configuration in the invention, it is advantageous that low temperature curing is implemented by means of high frequencies and positions of particles can be controlled by means of a magnetic field in adhering IC, e.g., LCD displays, so that high connection reliability is achieved for connection electrodes of fine pitches.

## Description

### BACKGROUND OF THE INVENTION

### 1. Technical field

The invention relates to an anisotropic conductive film and an adhesion method thereof and, more particularly, to an anisotropic conductive film and an adhesion method thereof, which enables damages of parts by heat to be avoided by means of cold curing with high frequencies in adhering IC's, e.g., LCD displays, and of achieving high connection reliability for connection electrodes of micro pitches by means of particle control with a magnetic field.

### 2. Description of the Prior Art

In general, an anisotropic conductive film (ACF) is an adhesive film used for connecting connection electrodes for electric circuits of opposite functions. In a process of adhering the film, conductivity and adhesiveness is required in a direction of film thickness. Insulation performance is also required in a surface direction and advanced functions are required for a method of adhering the films.

For example, in a process of producing flat panel displays (FPD), the method of adhering a driver IC to a FPD is migrating from the Quad Flat Package (QFP) to Tape Automated Bonding(TAB), Chip On Film (COF), and Chip On Glass (COG). Implementing functions of an anisotropic conductive film requires cold curing in all adhering methods. Such a method as COG highly requires connection reliability in fine pitches as well as cold curing.

The anisotropic conductive film is produced to contain conductive particles in an insulating adhesive serving as a binder. The adhesive is of thermosetting or thermoplastic resin only or a combination thereof. Examples of the conductive particles widely used include metallic particles, e.g., nickel, silver, etc., or styrene polymer resin particles plated with a conductive metallic film of, e.g., nickel, gold, etc.

As the pitches are made very fine and electrode areas are made very small, problems thereby occur, such as non-uniform connections and inter-pattern disconnection. In particular, in case of COG in which direct adhering to a display panel is applied, up to 10 µm in the pitch spacing is required, so that insulation performance in a surface direction of an adhesive film is very critical.

In order to meet above requirements, methods of producing an anisotropic conductive film with more functions are disclosed in the published KP No. 2000-0048223 and the registered KP No. 10-0435034. The published JP 62-40183 filed by Sony Co. discloses a method of achieving insulation performance among particles by coating conductive metallic particles with a resin insoluble in the adhesive to meet the requirement for fine pitches.

However, the prior art technologies as described above have a limit by using a method of providing a separate layer containing conductive particles, controlling the size of conductive particles or modifying the surface of conductive particles. That is, it is not easy to achieve insulation performance because of contact to neighboring conductive particles when conductive particles are destroyed or an insulation layer is easily peeled because of a process of adhering conductive films, subject to high temperature and pressure. Also, because of insufficient uniformity in thickness of the insulation layer, a problem may arise that conductivity is not implemented in adhering the film although high temperature and pressure is applied in a part of the very thick insulation layer.

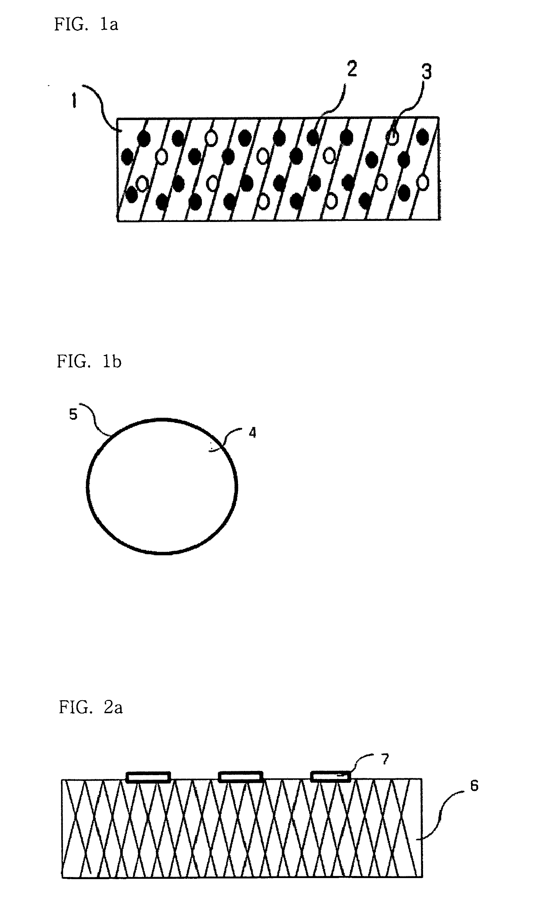

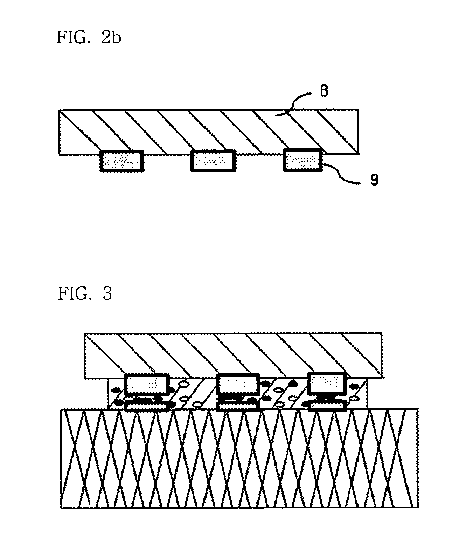

In the adhering process, a conductive film is first fixed on a panel as shown in Fig.2a. A driver IC is fixed in its position by means of pressure on a glass panel together with the conductive film at about 80 °C as shown in Fig.2b. Subsequently in order to cure the thermosetting resin included in the conductive film, the conductive film is pressed in a final form by applying a strong pressure of 30 to 50kg_{f}/mm² at a high adhering temperature of 200°C, as shown in Fig.3a. In this process, conventional conductive films have the problems as described above. In particular, with a repeated process of applying and eliminating heat, cooling and pressure, contraction stress involved in curing an adhesive film occur to lead to warpage panels and also contact resistance increasing in a thickness direction, so that connection reliability is significantly lowered, regardless of modification of the conductive particles as described above.

In order to alleviate thermal stress in an adhering process repeated as described above, those skilled in the art may contemplate a method of mixing a thermoplastic resin with a thermosetting adhesive. However, although it is helpful for alleviating stress in a cooling process, the elastic modulus of the thermoplastic resin is highly lowered at high temperature to cause problems in connection reliability and it is thus not considered a fundamental solution.

Therefore, there is a need of essential improvement for a conventional anisotropic conductive film, and, in particular, in a process of adhering the film, there is a need of a new conductive film and a process of adhering the film that can be used at low temperature and low pressure.

### BRIEF SUMMARY OF THE INVENTION

The invention concerns an anisotropic conductive film devised to address the aforementioned problems, and, more particularly, it is an object of the invention to provide an anisotropic conductive film and an adhesion method thereof, with which it is possible to achieve electric conductivity by including super-paramagnetic metal oxide nano-particles in the film and to achieve cold curing through particle control by means of a magnetic field, the anisotropic conductive film having high connection reliability with fine pitches.

The aforementioned and other object and advantages of the invention will become apparent to those skilled in the art from the following description illustrating a preferred embodiment of the invention with reference to the accompanying drawings.

An anisotropic conductive film according to a first aspect of the invention to achieve the aforementioned object of the invention is characterized in that it comprises (1) a thermosetting adhesive, (2) super-paramagnetic metal oxide nano-particles and (3) conductive particles.

Preferably, the anisotropic conductive film according to the first aspect of the invention is characterized in that the surface of the (2) super-paramagnetic metal oxide nano-particles is coated with organic or inorganic material.

More preferably, the anisotropic conductive film according to the first aspect of the invention is characterized in that the surface of the (2) super-paramagnetic metal oxide nano-particles coated with organic or inorganic material is plated with nickel and/or gold.

Preferably, the anisotropic conductive film according to the first aspect of the invention is characterized in that the (2) super-paramagnetic metal oxide nano-particles comprise oxides of Fe, Co, Ni, FePt, etc., and the size of super-paramagnetic metal oxide nano-particles is of 1 to 100 nm.

Also, preferably, the anisotropic conductive film according to the first aspect of the invention is characterized in that the surface of the (2) super-paramagnetic metal oxide nano-particles is coated with nickel and/or gold.

A method of adhering an anisotropic conductive film according to a second aspect of the invention to achieve the object of the invention is characterized in that it is a method of adhering the anisotropic conductive film by using a heating instrument and a separate magnetic field generator by means of an alternating filed of high frequencies.

### BRIEF DESCRIPTION OF THE DRAWINGS

The features and advantages of the present invention will become apparent from the following detailed description of a preferred embodiment thereof illustrated with reference to the accompanying drawings, in which:
Fig. 1a illustrates an anisotropic conductive film containing super-paramagnetic metal oxide nano-particles and conductive particles;
Fig.1b illustrates conductive particles coated with conductive metals of the invention;
Fig.2a illustrates a panel for adhering an anisotropic conductive film of the invention;
Fig.2b illustrates a driver IC for adhering an anisotropic conductive film of the invention;
Fig.3 illustrates a device configuration with an adhered anisotropic conductive film of the invention.

### DETAILED DESCRIPTION OF THE PREFERRED EMBODIMENT

Now, the invention will be described in more detail with reference to the embodiment and drawings of the invention. It will be apparent to those skilled in the art that the embodiment is intended to illustrate the invention in more detail, and the scope of the invention is not limited by the embodiment.

An anisotropic conductive film according to the invention comprises a thermosetting adhesive (Fig.1a-1), super-paramagnetic metal oxide nano-particles (Fig.1a-3), and conductive particles coated with metals (Fig. 1a-2, Fig.1b). The conductive particles and the super-paramagnetic metal oxide nano-particles are dispersed in the thermosetting composition (shown in Fig.1a)

The thermosetting adhesive is not limited to a specific type, provided that it exhibits adhesiveness by thermosetting. In particular, epoxy resin is used in the invention in that it is highly adhesive and humidity-resistant. Phenol resin may be used as a hardener for curing the epoxy resin. Thermoplastic resin may be included for alleviating stress.

The epoxy resin should have 2 or more functional groups, and may be one of cresol novolac resin, solid bisphenol A type, liquid bisphenol A type, bisphenol F, etc., having 100 to 1000 of weight per equivalent epoxy (WPE). In particular, the novolac epoxy resin is preferred because it is highly heat-resistant.

The hardener for curing the epoxy resin is not limited to a specific type, provided that it is able to cure the epoxy resin. In case of curing the novolac epoxy resin, in particular, it is desirable to use novolac phenol resin. In order to facilitate curing of the epoxy resin, a curing facilitating agent may be used. Examples of the curing facilitating agent include imidasol compounds and amines.

The amount of the phenol resin used as a hardener is generally 10 to 70 parts by weight, and preferably 30 to 50 parts by weight on the basis of 100 parts by weight of the epoxy resin. Furthermore, the amount of the curing facilitating agent used to facilitate curing of the epoxy resin is generally 0.01 to 10 parts by weight, and preferably 1 to 3 parts by weight on the basis of 100 parts by weight of a total amount of the epoxy resin and the hardener. Where the amount of the curing facilitating agent is more than 10 parts by weight, curing of the epoxy resin is facilitated too much in the process of adhering a conductive film, which may in turn cause adhesiveness between electrodes to be lost during the adhering process. Where the amount of the curing facilitating agent is not more than 0.01 parts by weight, curing speed is slow, so that additional curing time is required.
Next, the super-paramagnetic metal oxide nano-particles of the invention are not limited to a specific type, provided that they are super-paramagnetic (SPM) in a nano particle phase. They may be oxides of Fe, Co, Ni, FePt, etc. In particular, in the invention iron oxides may be used in that it is easy to produce and yield them, and exemplary preferred iron oxides used in the invention include iron oxides of maghemite (γ-Fe₂O₃) or magnetite (Fe₃O₄).

Super-paramagnetism is a phenomenon that a material exists without magnetism when there is no external magnetic field, but it becomes magnetic when it is exposed to an external magnetic field. If a magnetic substance of metallic oxides is at an ultrafine particle phase in a size of 1 to 100 nanometers, the particles become super-paramagnetic and behave as micro magnets when an external magnetic field is applied. In the invention, such a phenomenon was noted and the inventors conceived that it is possible to control positions of fine particles by means of an external magnetic field by including super-paramagnetic metal oxide nano-particles having the aforementioned properties in a conductive film.

That is, when an external magnetic field is applied in adhering the conductive film including the super-paramagnetic metal oxide nano-particles, the super-paramagnetic metal oxide nano-particles affected by the magnetic field are fixed in positions by means of the magnetic force. And although the adhesive is also melt to flow between the particles while giving a shearing force to the particles, flowing performance of the adhesive is fully overcome. Consequently, the positions of the super-paramagnetic metal oxide nano-particles insulating between the neighboring conductive particles are fixed to act as a kind of a spacer, so that it is possible to easily achieve insulation between very fine pitches in a surface direction of a film. As such, it is possible to produce pitches of 1µm or so, which is a required pitch level, smaller than 10µm. The invention will be applicable to the field of semiconductor chips as well as fine pitches in LCD displays in the future.

In addition to the idea that the position of particles can be controlled by means of super-paramagnetism of super-paramagnetic metal oxide nano-particles in the invention, another important idea is that the inventors noted that super-paramagnetic metal oxide nano-particles quickly vibrate to generate heat when they were exposed to the alternating magnetic field of high frequencies, and conceived that it was possible to cure conductive films by means of high frequencies without applying heat at high temperature from the outside in adhering the conductive films with the vibration and heat of the particles.

That is, when high frequencies are applied, the super-paramagnetic metal oxide nano-particles generate heat by means of disorderly electron movement thereof, and it is possible to control heat generating temperature according to frequency. Since magnetic particles are distributed uniformly in the conductive film, it is possible fully to cure the adhesive components around the particles within a short time even at low temperature. Therefore, since it is possible to cure the adhesive by means of generated heat without raising surface temperature of adhered parts, a conventional adhering process disadvantageously subject to high temperature is not required and it is thus possible to protect LCD display parts from damages easily. Therefore, it is possible to significantly enhance productivity of the IC adhering process such as LCD displays, and parts reliability.

As described above, two main ideas of the invention, considered as very novel and creative ideas, are that it is possible to cure a conductive film in a short time even at low temperature by means of high frequencies and positions of particles are controlled by means of a magnetic field. To this end, the invention proposing a new anisotropic conductive film containing super-paramagnetic metal oxide nano-particles significantly improves prior art technologies by a new approach, and also provides a new type of an anisotropic conductive film.

In the invention, the amount of the super-paramagnetic metal oxide nano-particles is generally 2 to 50 parts by weight, preferably 5 to 30 parts by weight and more particularly 10 to 20 parts by weight, on the basis of 100 parts by weight of an adhesive.

Where more than 50 parts by weight of super-paramagnetic metal oxide nano-particles are used, too many particles exist in the composition for producing the anisotropic conductive film of the invention, and conductivity may thus be lowered in a thickness direction of the film because the magnetic particles surround conductive particles. Where 2 or smaller parts by weight of the magnetic particles are used, it is hard to control positions thereof by means of a magnetic force and the effect of heating by means of high frequencies is not as great as required.

The size of the super-paramagnetic metal oxide nano-particles is preferably 1 to 100 nm because they must be super-paramagnetic.

The super-paramagnetic metal oxide nano-particles may be produced and yielded in known conventional manners to be nanometers in size or those commercially available in the market may be used.

The super-paramagnetic metal oxide nano-particles may be coated in order to enhance magnetic stability at a super-nano-particle phase and also dispersion stability in mixing them with an adhesive.

For example, in this case, the super-paramagnetic metal oxide nano-particles may be coated with, but not limited to, organic and inorganic materials, provided that they can be used for coating the particles. Various coating schemes may be used, e.g., having several coat layers of, for example, an inorganic material layer on another inorganic material layer, an organic material layer on an inorganic material layer, or an organic material layer on another organic material layer, or an inorganic material layer on an organic material layer. The invention is not limited to the aforementioned exemplary coating schemes.

In the invention, silica (SiO₂) may be selected from inorganic materials and used to coat the surface of the super-paramagnetic metal oxide nano-particles because of a good coating yield of the super-paramagnetic metal oxide nano-particles and because it is easy to produce silica. Among organic materials, polymer resins, preferably thermoplastic resins or thermosetting resins may be used for coating. More preferably, in terms of good compatibility with an adhesive, epoxy resins may be used for coating but the coating material in the invention is not limited specifically to them and may be selected from other materials for coating.

It should be noted that the size of the coated super-paramagnetic metal oxide nano-particles in dispersion is not greater than 200 nm.

Next, the conductive particles of the invention are not limited to a specific type, provided that the particles are conductive. Preferably, conductive particles conventionally known and commercially available in the market may be used. For example, conductive particles may be used, which are nickel particles plated with gold in order to prevent the particles from being oxidized. The conductive particles of the invention may be polymer resin particles coated with nickel-gold. The conductive particles may further be polymer resin particles plated with nickel-gold and then coated with polymer resins again.

More preferably, for the conductive particles, the super-paramagnetic metal oxide nano-particles specially described above may be plated with nickel-gold or silver-gold. As such, a conductive metallic film is formed on the surface of the super-paramagnetic metal oxide nano-particles. The size of the conductive particles produced as described above is even smaller than 2 to 8 microns which are a conventional size. Therefore, since there exist more conductive particles in a microelectrode thereby to enhance a contact density, it is possible to further improve connection reliability.

Also, the super-paramagnetic metal oxide nano-particles coated with organic or inorganic materials as described above may be used as conductive particles by plating the particles with nick-gold or silver-gold. By doing so, it is possible to control the size of the conductive particles in a desired level. Preferably, by producing and distributing large conductive particles as compared to the size of the super-paramagnetic metal oxide nano-particles, it is easy to control the conductive particles.

The average size of the conductive particles is not greater than 2 µm and may become smaller as the pitches are made very small in a later process.

Also, the conductive particles as described above may have a small magnetic force with a large difference as compared to the magnetic force of the original super-paramagnetic metal oxide nano-particles. Therefore, because of partial mobility by the effect of flowability of an adhesive under an external magnetic field, desired electric connection can be achieved with electrodes.

In order to adhere an anisotropic conductive film configured as described above, required are a high frequency generator and a magnetic field generator, which can be replaced with a simple device configuration commercially available in the market.

### Embodiment

Hereinafter, the invention will be described in more detail with reference to the embodiment of the invention. In the following description, the term 'parts by weight' is referred to a weight portion, and means a weight of solids. It should be noted that the invention is not limited to this definition.

First, an adhesive resin solution is produced by mixing, in the solvent of methyl ethyl ketone, 100 parts by weight of cresol novolac epoxy resin (YDCN 8P, commercially available from Toto Kasei Co.), 50 parts by weight of phenol novolac resin (KPH2000, commercially available from Kolon Chemical Co.) and 0.02 parts by weight of 1-cyano ethyl-2-phenyl imidasol (Curesol 2PZ-CN, commercially available from Shikoku Kasei Industrial. Co.) and then agitating the mixture for 3 hours.

Subsequently, the adhesive resin solution is mixed with 20 parts by weight of conductive particles which were super-paramagnetic iron oxide nano-particles of maghemite (γ-Fe₂O₃) coated with bisphenol-A epoxy resin (YD128, commercially available from Toto Kasei Co.), the coated surface of which is then plated with nickel-gold, and the resulting mixture is agitated for 30 minutes. The mixture is subsequently mixed with 15 parts by weight of super-paramagnetic iron oxide nano-particles of maghemite (γ-Fe₂O₃) coated with silica and the mixture is then agitated for 6 hours. The resulting solution is coated on a substrate of a polyterephthalate 38µm thick and the film is dried for 3 minutes at 90°C to produce an anisotropic conductive film at B stage, and 20µm thick.

The average particle diameter of the super-paramagnetic metal oxide nano-particles is 30 nm.

The average particle diameter of the super-paramagnetic metal oxide nano-particles coated with epoxy resin is 50 nm.

The average particle diameter of the conductive particles produced by coating the super-paramagnetic metal oxide nano-particles first coated with epoxy resin and then plated with nickel-gold is 70 nm and the average particle diameter of agglomerators is 500 nm.

The anisotropic conductive film of Fig.1a produced as described above was fixed on an LCD display panel having an ITO electrode at 40°C and a driver IC was then pressed as shown in Fig.2b. A magnetic field was then applied on a lower part of the panel to generate high frequencies with a high frequency induction coil device. The high frequencies at 5Kw to 280kHz are used to raise temperature to 100 °C by heating for 20 seconds and the adhesive started to cure at the same time as heating and lead to full curing after 20 seconds.

By the process as described above, it was possible to protect damages of parts and provide an anisotropic conductive film of high connection reliability with fine pitches and that was fully cured at low temperature.

With an anisotropic conductive film according to the invention as described above, it is advantageous that low temperature curing is implemented by means of high frequencies and positions of particles can be controlled by means of a magnetic field, so that connection reliability is not lowered for a connection electrode having fine pitches, since both of super-paramagnetic metal oxide nano-particles and conductive particles are dispersed in a thermosetting adhesive.

With the method of adhering an anisotropic conductive film according to the invention, it is advantageous that, through low temperature curing by means of high frequencies in adhering IC such as LCD displays, parts thereof can be protected from damages resulting from heat, and positions of particles can be controlled by means of a magnetic field

It should be noted that, within the scope of teaching and the subject of the invention, variations and modifications of the embodiment of the invention may be conceived by those skilled in the art, and the accompanied claims cover those variations and modifications without departing from the subject of the invention.

The use of the word "comprising", and its conjugates, does not exclude the presence of elements or steps other than those listed in any claims or the specification as a whole. The singular reference of elements does not exclude the plural reference of such elements and vice-versa.

### Description of reference numerals in the drawings

- 1.: thermosetting adhesive
- 2.: conductive particles
- 3.: super-paramagnetic metal oxide nano-particles
- 4.: core particle of conductive particles
- 5.: conductive metal film
- 6.: ITO glass panel
- 7.: panel electrode
- 8.: driver IC
- 9.: electrode bump

## Claims

1. An anisotropic conductive film, **characterized in that** it comprises:
(1) a thermosetting adhesive;
(2) super-paramagnetic metal oxide nano-particles; and
(3) conductive particles.

2. The anisotropic conductive film as claimed in claim 1, **characterized in that** the surface of the (2) super-paramagnetic metal oxide nano-particles is coated with organic or inorganic material.

3. The anisotropic conductive film as claimed in claim 2, **characterized in that** the surface of the (2) super-paramagnetic metal oxide nano-particles coated with organic or inorganic material is plated with nickel and/or gold.

4. The anisotropic conductive film as claimed in claim 1, **characterized in that** the (2) super-paramagnetic metal oxide nano-particles comprise oxides of Fe, Co, Ni, FePt, etc., and the size of super-paramagnetic metal oxide nano-particles is of 1 to 100 nm.

5. The anisotropic conductive film as claimed in claim 1, **characterized in that** the surface of the (2) super-paramagnetic metal oxide nano-particles is plated with nickel and/or gold.

6. A method of adhering an anisotropic conductive film as claimed in any one of claims 1 to 5, **characterized in that** the film is adhered by means of a heating instrument using an alternating field of high frequencies and a separate magnetic field generator.
